Europäisches Patentamt

European Patent Office

Office européen des brevets

(11) Veröffentlichungsnummer : **0 579 045 B1**

(12) **EUROPÄISCHE PATENTSCHRIFT**

(45) Veröffentlichungstag der Patentschrift :
**22.02.95 Patentblatt 95/08**

(21) Anmeldenummer : **93110500.1**

(22) Anmeldetag : **01.07.93**

(51) Int. Cl.⁶ : **H01L 31/11, H01L 27/144**

(54) **Anordnung mit einer integrierten farbselektiven Photodiode und einem der Photodiode nachgeschalteten Verstärker.**

(30) Priorität : **16.07.92 CH 2269/92**

(43) Veröffentlichungstag der Anmeldung :
**19.01.94 Patentblatt 94/03**

(45) Bekanntmachung des Hinweises auf die
Patenterteilung :
**22.02.95 Patentblatt 95/08**

(84) Benannte Vertragsstaaten :
**CH DE FR GB IT LI**

(56) Entgegenhaltungen :
**EP-A- 0 296 371
EP-A- 0 353 509**

(56) Entgegenhaltungen :
**EP-A- 0 387 483
PATENT ABSTRACTS OF JAPAN vol. 10, no.
99 (E-396)(2156) 16. April 1986
PATENT ABSTRACTS OF JAPAN vol. 8, no.
264 (E-282)(1701) 4. Dezember 1984
NEW ELECTRONICS Bd. 20, Nr. 17, 1. September 1987, LONDON GB Seiten 33 - 35 D.COOK
'LIGHT SENSING WITH OPTICAL ICs'**

(73) Patentinhaber : **Landis & Gyr Technology
Innovation AG
CH-6301 Zug (CH)**

(72) Erfinder : **Radivoje, Popovic
Fridbach 1
CH-6300 Zug (CH)**

EP 0 579 045 B1

## Beschreibung

Die Erfindung bezieht sich auf eine Anordnung mit einer integrierten farbselektiven Photodiode und einem der Photodiode nachgeschalteten Verstärker gemäss dem Oberbegriff des Anspruchs 1.

Aus der GB 2 244 175 A ist der Einbau in einem einzigen Gehäuse einer aus der Fig. 9 der US 4 910 570 A bekannten farbselektiven integrierten Photodiode und eines zugehörigen nachgeschalteten Verstärkers bekannt. Die farbselektive integrierte Photodiode enthält unter einem mit einem Antireflexionsbelag versehenen und Licht selektiv durchlässigen Eintrittsfenster eine erste Halbleiterschicht eines ersten Leitfähigkeitstyps $P^{++}$, die an der Oberfläche in einer zweiten Halbleiterschicht eines zweiten Leitfähigkeitstyps $N^+$ angeordnet ist, welche letztere an der Oberfläche in einer dritten Halbleiterschicht des ersten Leitfähigkeitstyps P angeordnet ist, wobei die letztere als Substrat ausgebildet ist. Alle drei Halbleiterschichten besitzen je einen ohmschen Anschlusskontakt. Der Antireflexionsbelag ist als Interferenzfilter wirksam, welches mittels sich abwechselnder Oxid- und Metallschichten aufgebaut ist. Vor dem Interferenzfilter ist ausserdem noch ein Farbfilter angeordnet.

Der Erfindung liegt die Aufgabe zugrunde, die eingangs genannte Anordnung so zu verbessern, dass die farbselektive Photodiode und der nachgeschaltete Verstärker in einem einzigen Halbleiter-Chip integrierbar sind.

Die genannte Aufgabe wird erfindungsgemäss durch die im Kennzeichen des Anspruchs 1 angegebenen Merkmale gelöst.

Vorteilhafte Ausgestaltungen der erfindungsgemässen Anordnung ergeben sich aus den abhängigen Ansprüchen.

Ein Ausführungsbeispiel der Erfindung ist in der Zeichnung dargestellt und wird im folgenden näher beschrieben.

Es zeigen:

Fig. 1    ein Schaltbild eines von einer farbselektiven Photodiode angesteuerten Verstärkers,

Fig. 2    einen Querschnitt eines Aufbaus einer bekannten integrierten farbselektiven Photodiode einer erfindungsgemässen Anordnung,

Fig. 3    einen Querschnitt eines Aufbaus eines Vertikal-Bipolartransistors des Verstärkers der erfindungsgemässen Anordnung,

Fig. 4    einen Querschnitt eines Aufbaus eines Lateral-Bipolartransistors des Verstärkers der erfindungsgemässen Anordnung,

Fig. 5    einen Querschnitt eines bekannten Aufbaus eines integrierten Widerstandes des Verstärkers der erfindungsgemässen Anordnung,

Fig. 6    einen Querschnitt eines neuartigen Aufbaus eines integrierten Widerstandes des Verstärkers der erfindungsgemässen Anordnung und

Fig. 7    ein elektrisches Schaltbild des in der Fig. 6 dargestellten integrierten Widerstandes.

Gleiche Bezugszahlen bezeichnen in allen Figuren der Zeichnung gleiche Teile.

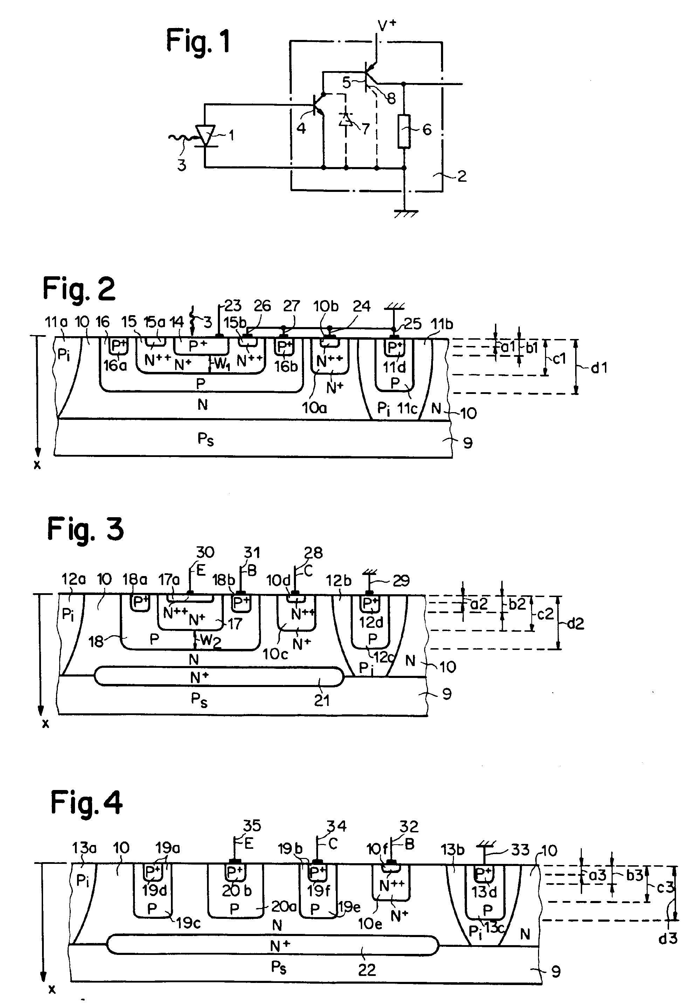

In der erfindungsgemässen Anordnung ist eine integrierte farbselektive Photodiode 1 mit einem z. B. zweipoligen Eingang eines der Photodiode 1 nachgeschalteten Verstärkers 2 verbunden, der somit der Photodiode 1 elektrisch nachgeschaltet ist. Die Photodiode 1 wertet z. B. ultraviolettes oder gelbes Licht 3 aus. Der Verstärker 2 enthält mindestens einen Vertikal-Bipolartransistor 4 und besitzt z. B. den in der Fig. 1 dargestellten und an sich bekannten Aufbau. In diesem Fall bildet die Basis des Vertikal-Bipolartransistors 4 einen ersten Pol des zweipoligen Eingangs des Verstärkers 2, an dem z. B. die Anode der Photodiode 1 angeschlossen ist, während der Kollektor des Vertikal-Bipolartransistors 4 mit einer Basis eines Lateral- Bipolartransistors 5 verbunden ist, dessen Kollektor einen Ausgang des Verstärkers 2 bildet. Der Vertikal-Bipolartransistor 4 ist z. B. ein NPN-Transistor, während der Lateral-Bipolartransistor 5 z. B. ein PNP-Transistor ist. Der Emitter des Lateral-Bipolartransistors 5 liegt dann an einem positiven Pol $V^+$ einer Speisegleichspannung, deren anderer in der Fig. 1 nicht dargestellter Pol z. B. an Masse liegt. In diesem Fall ist auch der zweite Pol des zweipoligen Eingangs des Verstärkers 2 und der Emitter des Vertikal-Bipolartransistors 4 unmittelbar sowie der Kollektor des Lateral-Bipolartransistors 5 über einen integrierten Widerstand 6 mit der Masse verbunden. Der integrierte Widerstand 6 dient z. B. der Temperaturkompensation der Stromverstärkungen der Bipolartransistoren 4 und 5. In der Fig. 1 sind gestrichelt zusätzlich noch eine Streudiode 7, die zwischen dem Kollektor und dem Emitter des Vertikal-Bipolartransistors 4 vorhanden ist, und ein Streukollektor 8 des Lateral-Bipolartransistors 5 dargestellt, der mit der Masse verbunden ist.

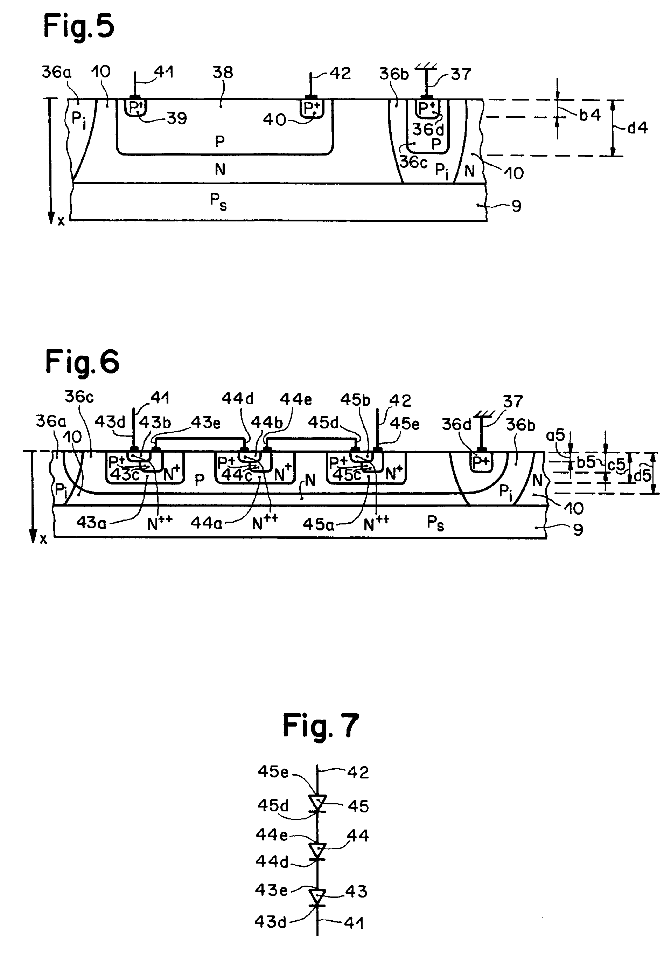

Die Photodiode 1 und der Verstärker 2 mitsamt seinen Bipolartransistoren 4 und 5 sowie seinem Widerstand 6 sind in einer einzigen integrierten Schaltung integriert, obwohl die Photodiode 1, die Bipolartransistoren 4 und 5 sowie der Widerstand 6 in den Figuren 2 bis 6 getrennt dargestellt sind. Die integrierte Schaltung enthält ein für alle integrierte Bauelemente gemeinsames Substrat 9, auf dem eine einzige ebenfalls gemeinsame Epitaxieschicht 10 angeordnet ist, die auf an sich bekannte Weise in nebeneinander liegenden und gegeneinander elektrisch isolierten Inseln aufgeteilt ist, in denen je eines der Bauelemente 1, 4, 5, 6, usw. angeordnet ist. Eine Inselbildung erfolgt dabei jeweils mittels eines rohrförmigen, über die ganze Tiefe der Epitaxieschicht 10 reichenden und die betreffende Insel seitlich umgebenden Isolationsringes 11a;11b (siehe Fig. 2) bzw. 12a;12b (siehe Fig. 3) bzw. 13a;13b (siehe Fig. 4) bzw. 36a;36b (siehe Figuren 5 und 6), von dem in der Zeichnung jeweils wegen der rohrförmigen Gestalt zwei Querschnittflächen 11a und 11b bzw. 12a und 12b bzw. 13a und 13b bzw. 36a und 36b dargestellt sind.

In der erfindungsgemässen Anordnung werden Zonen und Anschlusskontakte aus Halbleitermaterial eines ersten Leitfähigkeitstyps P oder N und eines zweiten Leitfähigkeitstyps N bzw. P verwendet. Aus Gründen der Einfachheit und der Übersichtlichkeit gilt nachfolgend und in der Zeichnung jeweils die Annahme, dass der erste Leitfähigkeitstyp P und der zweite Leitfähigkeitstyp N ist. Dabei ist jeweils wohlverstanden, dass das Umgekehrte in der erfindungsgemässen Anordnung auch möglich ist.

Das Substrat 9 und die Isolationsringe 11a;11b, 12a;12b, 13a;13b und 36a;36b bestehen jeweils aus einem Halbleitermaterial des ersten Leitfähigkeitstyps P und die Epitaxieschicht 10 aus einem Halbleitermaterial des zweiten Leitfähigkeitstyps N. Jeder Isolationsring 11a;11b, 12a;12b, 13a;13b und 36a;36b enthält an seiner Oberfläche einen Anschlusskontakt 11c;11d (siehe Fig. 2) bzw. 12c;12d (siehe Fig. 3) bzw. 13c;13d (siehe Fig. 4) bzw. 36c;36d (siehe Figuren 5 und 6), der jeweils aus einem grösseren Anschlusskontakt 11c bzw. 12c bzw. 13c bzw. 36c des ersten Leitfähigkeitstyps P besteht, in dem an der Oberfläche jeweils ein stärker mit Fremdatomen dotierter kleinerer Anschlusskontakt 11d bzw. 12d bzw. 13d bzw. 36d angeordnet ist, der ebenfalls vom ersten Leitfähigkeitstyp P ist. Ähnlich enthält die Epitaxieschicht 10 mindestens in jeder zur Photodiode 1 und zu den Bipolartransistoren 4 und 5 gehörenden Insel an ihrer Oberfläche einen Anschlusskontakt 10a;10b (siehe Fig. 2) bzw. 10c;10d (siehe Fig. 3) bzw. 10e;10f (siehe Fig. 4), der jeweils aus einem grösseren Anschlusskontakt 10a bzw. 10c bzw. 10e des zweiten Leitfähigkeitstyps N besteht, in dem an der Oberfläche jeweils ein stärker mit Fremdatomen dotierter kleinerer Anschlusskontakt 10b bzw. 10d bzw. 10f angeordnet ist, der ebenfalls vom zweiten Leitfähigkeitstyp N ist.

Die in der Fig. 2 dargestellte bekannte integrierte farbselektive Photodiode 1 weist neben dem Substrat 9, der Epitaxieschicht 10 mit ihrem Anschlusskontakt 10a;10b und dem Isolationsring 11a;11b mit seinem Anschlusskontakt 11c;11d noch eine erste Halbleiterzone 14 des ersten Leitfähigkeitstyps P auf, die an der Oberfläche einer zweiten Halbleiterzone 15 in der letzteren angeordnet ist, welche ihrerseits vom zweiten Leitfähigkeitstyp N ist und an der Oberfläche einer dritten Halbleiterzone 16 in der letzteren angeordnet ist, welche vom ersten Leitfähigkeitstyp P ist. Die dritte Halbleiterzone 16 ist an der Oberfläche in einem der Photodiode 1 zugeordneten Teil der Epitaxieschicht 10 angeordnet, der von dem Isolationsring 11a;11b seitlich ringförmig umgeben ist. An der Oberfläche ist in der zweiten und der dritten Halbleiterzone 15 und 16 der Photodiode 1 ein rohrförmiger Anschlusskontakt 15a;15b des zweiten Leitfähigkeitstyps N bzw. 16a;16b des ersten Leitfähigkeitstyps P jeweils so angeordnet, dass er die erste bzw. zweite Halbleiterzone 14 bzw. 15 seitlich ringförmig umgibt. Die Anschlusskontakte 15a;15b und 16a;16b sind in der Fig. 2 wegen der rohrförmigen Gestalt jeweils durch zwei Querschnittflächen 15a und 15b bzw. 16a und 16b dargestellt.

Der Verstärker 2 enthält mindestens den Vertikal- Bipolartransistor 4, der in einer gleichen integrierten Schaltung wie die Photodiode 1 und von der letzteren elektrisch isoliert angeordnet ist. Der in der Fig. 3 dargestellte Vertikal-Bipolartransistor 4 weist neben dem Substrat 9, der Epitaxieschicht 10 mit ihrem Anschlusskontakt 10c;10d und dem Isolationsring 12a;12b mit seinem Anschlusskontakt 12c;12d noch eine Emitterzone 17 vom zweiten Leitfähigkeitstyp N auf, welche eine ähnliche Dotierung und Schichtdicke c2 besitzt wie die zweite Halbleiterzone 15 der Photodiode 1 und welche an der Oberfläche einer Basiszone 18 des Vertikal-Bipolartransistors 4 in der Basiszone 18 angeordnet ist. Die Basiszone 18 ist vom ersten Leitfähigkeitstyp P. Sie besitzt eine ähnliche Dotierung und Schichtdicke d2 wie die dritte Halbleiterzone 16 der Photodiode 1 und ist an der Oberfläche der Epitaxieschicht 10 in einem dem Vertikal-Bipolartransistor 4 zugeordneten Teil der Epitaxieschicht 10 angeordnet, der vom Isolationsring 12a;12b seitlich ringförmig umgeben ist und eine Kollektorzone des Vertikal-Bipolartransistors 4 bildet. An der Oberfläche ist in der Emitterzone 17 und der Basiszone 18 des Vertikal-Bipolartransistors 4 ein Anschlusskontakt 17a des zweiten Leitfähigkeitstyps N bzw. 18a;18b des ersten Leitfähigkeitstyps P angeordnet, wobei der letztere rohrförmig und jeweils so angeordnet ist, dass er die Emitterzone 17 seitlich ringförmig umgibt. Der Anschlusskontakt 18a;18b ist in der Fig. 3 wegen der rohrförmigen Gestalt durch zwei Querschnittflächen 18a und 18b dargestellt.

Wenn der Verstärker 2 mindestens einen Lateral-Bipolartransistor 5 enthält, ist dieser in der gleichen integrierten Schaltung wie die Photodiode 1 und der Vertikal-Bipolartransistor 4 sowie von den beiden letzteren elektrisch isoliert angeordnet. Wie in der Fig. 4 dargestellt, enthält der Lateral-Bipolartransistor 5 neben dem Substrat 9, der Epitaxieschicht 10 mit ihrem Anschlusskontakt 10e;10f und dem Isolationsring 13a;13b mit seinem Anschlusskontakt 13c;13d noch eine zentrale Emitterzone 20a;20b und eine rohrförmige Kollektorzone 19a;19b. Die beiden letzteren sind vom ersten Leitfähigkeitstyp P. Sie besitzen eine ähnliche Dotierung und Schichtdicke d3 wie die dritte Halbleiterzone 16 der Photodiode 1 und sind an der Oberfläche der Epitaxieschicht 10 in einem dem Lateral-Bipolartransistor 5 zugeordneten Teil der Epitaxieschicht 10 angeordnet, der vom Isolationsring 13a;13b seitlich ringförmig umgeben ist und eine Basiszone des Lateral-Bipolartransistors 5 bildet. Die rohrförmige Kollektorzone 19a;19b ist so angeordnet, dass sie die zentrale Emitterzone 20a;20b, getrennt durch Halbleitermaterial der Epitaxieschicht 10, seitlich ringförmig umgibt. Die Kollektorzone 19a;19b besteht aus einer rohrförmigen grösseren Halbleiterzone 19c;19e, in der an der Oberfläche jeweils ein stärker mit Fremdatomen dotierter rohrförmiger kleinerer Anschlusskontakt 19d;19f angeordnet ist, der vom gleichen ersten Leitfähigkeitstyp P ist wie die rohrförmige grössere Halbleiterzone 19c;19e. Die Emitterzone 20a;20b besteht aus einer grösseren Halbleiterzone 20a, in der an der Oberfläche ein stärker mit Fremdatomen dotierter kleinerer Anschlusskontakt 20b angeordnet ist, der vom gleichen ersten Leitfähigkeitstyp P ist wie die grössere Halbleiterzone 20a. Die Halbleiterzonen 19a;19b und 19c;19e sowie der Anschlusskontakt 19d;19f sind in der Fig. 4 wegen der rohrförmigen Gestalt jeweils durch zwei Querschnittflächen 19c;19d und 19e;19f bzw. 19c und 19e bzw. 19d und 19f dargestellt.

Zur Reduktion des Widerstandswertes der Kollektorzone besitzt der Vertikal-Bipolartransistor 4 an der Grenzfläche zwischen dem Substrat 9 und der Epitaxieschicht 10 vorzugsweise eine sogenannte "Vergrabene Halbleiterschicht" ("Buried layer") 21. Zur Erzeugung einer Diffusions-Barriere, die verhindert, dass Minoritätsträger aus der Epitaxieschicht 10 in das Substrat 9 diffundieren, besitzt der Lateral-Bipolartransistor 5 an der Grenzfläche zwischen dem Substrat 9 und der Epitaxieschicht 10 vorzugsweise ebenfalls eine sogenannte "Vergrabene Halbleiterschicht" 22. Die "Vergrabenen Halbleiterschichten" 21 und 22 sind jeweils vom zweiten Leitfähikeitstyp N und stark mit Fremdatomen dotiert. Sie bedecken jeweils den grössten Teil des Bodens der in der Epitaxieschicht 10 vorhandenen Insel, die dem betreffenden Bipolartransistor 4 bzw. 5 zugeordnet ist.

Der Verstärker 2 enthält mindestens einen integrierten Widerstand 6, der in der gleichen integrierten Schaltung wie die Photodiode 1 und die Bipolarttransistoren 4 und 5 sowie von diesen allen elektrisch isoliert angeordnet ist. Ein in der Fig. 5 dargestellter bekannter Aufbau eines integrierten Widerstandes 6 weist neben dem Substrat 9, der Epitaxieschicht 10 und dem Isolationsring 36a;36b mit dessem über einen externen elektrischen Anschluss 37 an Masse liegenden Anschlusskontakt 36c;36d noch eine implantierte Widerstands-Halbleiterzone 38 vom ersten Leitfähigkeitstyp P auf, welche eine ähnliche Dotierung und Schichtdicke d4 besitzt wie die dritte Halbleiterzone 16 der Photodiode 1 und an der Oberfläche der Epitaxieschicht 10 in dem dem integrierten Widerstand 6 zugeordneten Teil der Epitaxieschicht 10 angeordnet ist. An der Oberfläche sind in der Widerstands-Halbleiterzone 38 zwei Halbleiter-Anschlusskontakte 39 und 40 des ersten Leitfähigkeitstyps P angeordnet, die beide stark mit Fremdatomen dotiert sind.

Ein in der Fig. 6 dargestellter neuartiger Aufbau des integrierten Widerstandes 6 enthält ebenfalls das Substrat 9, die Epitaxieschicht 10 und den Isolationsring 36a;36b mit dessem über einen externen elektrischen Anschluss 37 an Masse liegenden Anschlusskontakt 36c;36d. Der grössere Anschlusskontakt 36c des Anschlusskontaktes 36c;36d besitzt dabei die Gestalt einer Halbleiter-Wanne, die an der Oberfläche der Epitaxieschicht 10 in einem dem Widerstand 6 zugeordneten Teil der Epitaxieschicht 10 so angeordnet ist, dass sie mindestens teilweise im oberen Teil des Isolationsringes 36a;36b enthalten ist und diesen somit mindestens teilweise überlappt. Dabei ist der kleinere Anschlusskontakt 36d vorzugsweise im gemeinsamen Teil des grösseren Anschlusskontaktes 36c und des Isolationsringes 36a;36b angeordnet. Die Halbleiter-Wanne 36c des ersten Leitfähigkeitstyps P besitzt eine ähnliche Dotierung und Schichtdicke d5 wie die dritte Halbleiterzone 16 der Photodiode 1. Der Widerstand 6 in seinem neuartigen Aufbau weist eine Reihenschaltung mehrerer gleichgepolter P/N-Dioden auf, wie sie in der Fig. 7 dargestellt ist. In der Fig. 6 und in der Fig. 7 gilt jeweils die Annahme, dass der Widerstand 6 eine Reihenschaltung dreier P/N-Dioden 43, 44 und 45 aufweist. An der Oberfläche sind in der Halbleiter-Wanne 36c soviele voneinander getrennte kleinere Halbleiter-Wannen 43a, 44a und 45a des zweiten Leitfähigkeitstyps N angeordnet, wie Anzahl P/N-Dioden im integrierten Widerstand 6 enthalten sind, wobei die kleineren Halbleiter-Wannen 43a, 44a und 45a jeweils durch das Halbleitermaterial der Halbleiter-Wanne 36c gegeneinander elektrisch isoliert sind. Die kleineren Halbleiter-Wannen 43a, 44a und 45a besitzen jeweils eine ähnliche Dotierung und Schichtdicke c5 wie die zweite Halbleiterzone 15 der Photodiode 1. In jeder kleineren Halbleiter-Wanne 43a, 44a und 45a sind an der Oberfläche zwei Anschlusskontakte 43b und 43c bzw. 44b und 44c bzw. 45b und 45c angeordnet, die sich beide mindestens teilweise überlappen und beide stark mit Fremdatomen dotiert sind. Ein erster der beiden Anschlusskontakte 43c bzw. 44c bzw. 45c ist dabei jeweils vom ersten Leitfähigkeitstyp P und ein zweiter der beiden Anschlusskontakte 43b, 44b und 45b jeweils vom zweiten Leitfähigkeitstyp N.

Der Widerstand 6 des Verstärkers 2 kann ein in der Fig. 5 dargestellter Widerstand oder ein in der Fig. 6 dargestellter Widerstand oder eine Kombination beider Arten von Widerständen sein. Im letzteren Fall ist er eine geeignete Reihen- und/oder Parallelschaltung der beiden Arten von Widerständen.

Der in der Fig. 5 dargestellte Widerstand 6 besitzt einen positiven Temperaturkoeffizient und einen Wert von höchstens 1 MΩ. Der in der Fig. 6 dargestellte Widerstand 6 besitzt einen negativen Temperaturkoeffizient und einen Wert von etwa 100kΩ bis ungefähr 1 GΩ. Wegen den hohen Dotierungen $N^{++}$ bzw. $P^+$ und geringen Tiefen der Anschlusskontakte 43b, 43c, 44b, 44c, 45b und 45c entsteht im letzteren Widerstand bereits bei einer tiefen Spannung in der Grössenordnung von Millivolts ein Tunneleffekt der Ladungsträger am Übergang zwischen jedem der beiden sich überlappenden Anschlusskontakte 43b und 43c bzw. 44b und 44c bzw. 45b und 45c, so dass die Dioden 43, 44 und 45 jeweils wie eine Art "Backward diode" funktionieren und im Bereich von etwa - 50mV bis + 50mV eine annähernd lineare Spannungs/Strom-Kennlinie besitzen. Durch eine geeignete Wahl einer Reihen- und/oder Parallelschaltung der beiden Arten von Widerständen kann ein integrierter Widerstand 6 in der Grössenordnung von 10 MΩ bis 100 MΩ realisiert werden, der einen vorgegebenen Temperaturkoeffizient, z. B. - 0,5 %/°Kelvin besitzt. Da die beiden Bipolartransistoren 4 und 5 für ihre Stromverstärkung typischerweise je einen positiven Temperaturkoeffizient, z. B. + 0,25 %/°Kelvin, aufweisen, kann mit einem negativen Temperaturkoeffizient des Widerstandes 6 die erfindungsgemässe Anordnung temperaturunempfindlich gemacht werden.

Wegen den unterschiedlichen Dotierungen ist das Halbleitermaterial des Substrats 9 mit $P_s$ ("$P_{substrat}$"), dasjenige der Isolationsringe 11a;11b, 12a;12b, 13a;13b und 36a;36b mit $P_i$ ("$P_{isolation}$"), dasjenige der Halbleiterzonen 16, 18 und 38 sowie der Anschlusskontakte 11c, 12c, 13c, 19c;19e, 20a und 36c mit P und dasjenige der Halbleiterzone 14 sowie der Anschlusskontakte 11d, 12d, 13d, 16a;16b, 18a;18b, 19d;19f, 20b, 39, 40, 43c, 44c und 45c mit $P^+$ bezeichnet, welches letzteres Halbleitermaterial stärker mit Fremdatomen, vorzugsweise Boratomen, dotiert ist als das mit P bezeichnete Halbleitermaterial. Das Halbleitermaterial der Epitaxieschicht 10 ist mit N, dasjenige der Halbleiterzonen 15, 17, 21 und 22, der Halbleiter-Wannen 43a, 44a und 45a sowie der Anschlusskontakte 10a, 10c und 10e mit $N^+$ und dasjenige der Anschlusskontakte 10b, 10d, 10f, 15a;15b, 17a, 43b, 44b und 45b mit $N^{++}$ bezeichnet, welches letzteres Halbleitermaterial stärker mit Fremdatomen, vorzugsweise Phosphoratomen, dotiert ist als das mit $N^+$ bezeichnete Halbleitermaterial, welches seinerseits stärker mit Fremdatomen, vorzugsweise Phosphoratomen, dotiert ist als das mit N bezeichnete Halbleitermaterial.

In der Photodiode 1 ist auf der ersten Halbleiterzone 14 ein in der Fig. 2 nicht dargestelltes für das Licht 3 durchlässiges Eintrittsfenster angeordnet, welches ähnlich aufgebaut ist wie das aus der US 4 910 570 A bekannte Eintrittsfenster, dessen Antireflexionsbelag als Interferenzfilter wirksam ist. Die erfindungsgemässe Anordnung ist in einem Gehäuse angeordnet, welches vorzugsweise aus durchsichtigem Kunststoff besteht und die Rolle des Farbfilters übernimmt, welches im Stand der Technik vor dem Interferenzfilter angeordnet ist.

Die Halbleiterzone 14 sowie die Anschlusskontakte 10b, 11d, 15a;15b, 16a;16b, 10d, 12d, 17a, 18a;18b, 10f, 13d, 19d;19f, 20b, 36d, 39, 40, 43b, 43c, 44b, 44c, 45b und 45c besitzen je einen elektrischen Anschluss 23, 24, 25, 26, 27, 28, 29, 30, 31, 32, 33, 34, 35, 37, 41, 42, 43d, 43e, 44d, 44e, 45d bzw. 45e der in der Zeichnung jeweils als Drahtanschluss dargestellt ist, jedoch in der Praxis in der Regel aus einer sogenannten Metallisierung besteht, die auf der Oberfläche der integrierten Schaltung angeordnet ist. Die elektrischen Anschlüsse 24, 25, 26, 27, 29, 33 und 37 sind alle miteinander und mit der Masse verbunden (siehe Fig. 2, Fig. 3 und Fig. 4), so dass unter anderem in der Photodiode 1 die Halbleiterzonen 15 und 16, die Epitaxieschicht 10 sowie der Isolationsring 11a;11b alle an Masse liegen. Der Anschluss 23 bildet den Anodenanschluss der Photodiode 1. Die Anschlüsse 30, 31 und 28 bilden einen Emitter-Anschluss E, einen Basis-Anschluss B und einen Kollektor-Anschluss C des Vertikal-Bipolartransistors 4 (siehe Fig. 3). Die Anschlüsse 35, 34 und 32 bilden einen Emitter-Anschluss E, einen Kollektor-Anschluss C und einen Basis-Anschluss B des Lateral-Bipolartransistors 5 (siehe Fig. 4). Die elektrischen Anschlüsse 41 und 42 bilden die beiden Anschlüsse des in der Fig. 5 dargestellten Widerstandes 6. Der elektrische Anschluss 43e (siehe Fig. 6) ist extern mittels z. B. einer Metallisierung mit dem elektrischen Anschluss 44d und der elektrische Anschluss 44e extern mit dem elektrischen Anschluss 45d verbunden, so dass die den integrierten Widerstand 6 bildenden Dioden 43 bis 45 gleichgepolt elektrisch in Reihe geschaltet sind. Der elektrische Anschluss 43d bildet dann den ersten Pol 41 der Dioden-Reihenschaltung 43;44;45 und damit des Widerstandes 6, während der elektrische Anschluss 45e den zweiten Pol 42 der Dioden-Reihenschaltung 43;44;45 und damit des Widerstandes 6 bildet.

Die beiden Halbleiterzonen 14 und 15 bilden die PN-Schichten der Photodiode 1, während die Halbleiterzonen 17, 18 und 10 die Emitter-, Basis- und Kollektor-Zonen des Vertikal-Bipolartransistors 4 sind. Die Halbleiterzonen 20a, 19c;19e und 10 bilden die Emitter-, Kollektor- und Basis-Zonen des Lateral-Bipolartransistors 5, welcher letzterer das Substrat 9 als zusätzlichen Kollektor, nämlich als Streukollektor 8, besitzt, da die Zonen 20a, 10;22 und 9 im Lateral-Bipolartransistor 5 einen Streu-Vertikal-Bipolartransistor des Typs PNP bilden, der sich nur durch die Kollektorzone 9 bzw. 19c;19e vom Lateral-Bipolartransistor 5 unterscheidet. Im Vertikal-Bipolartransistor 4 bilden die "Vergrabene Halbleiterschicht" 21 und das Substrat 9 die Streudiode 7. Die Zonen 43c und 43a bzw. 44c und 44a bzw. 45c und 45a bilden jeweils die P/N-Schichten der P/N-Diode 43 bzw. 44 bzw. 45.

Die Anschlusskontakte 15a;15b und 10b der Photodiode 1 besitzen je eine Schichtdicke a1, die Anschlusskontakte 17a und 10d des Vertikal-Bipolartransistors 4 je eine Schichtdicke a2, der Anschlusskontakt 10f des Lateral-Bipolartransistors 5 eine Schichtdicke a3 sowie die Anschlusskontakte 43b, 44b und 45b des neuartigen Widerstandes 6 je eine Schichtdicke a5, die alle vier annähernd gleich gross sind.

Die erste Halbleiterzone 14 sowie die Anschlusskontakte 16a;16b und 11d der Photodiode 1 besitzen je eine Schichtdicke b1, die Anschlusskontakte 18a;18b und 12d des Vertikal-Bipolartransistors 4 je eine Schichtdicke b2, die Anschlusskontakte 19d;19f, 20b und 13d des Lateral-Bipolartransistors 5 je eine Schichtdicke b3, die Anschlusskontakte 39 und 40 je eine Schichtdicke b4 sowie die Anschlusskontakte 43c, 44c und 45c je eine Schichtdicke b5, die alle fünf annähernd gleich gross sind.

Die zweite Halbleiterzone 15 und der Anschlusskontakt 10a der Photodiode 1 besitzen je eine Schichtdicke c1, die Emitterzone 17 und der Anschlusskontakt 10c des Vertikal-Bipolartransistors 4 je eine Schichtdicke c2, der Anschlusskontakt 10e des Lateral-Bipolartransistors 5 eine Schichtdicke c3 sowie die Halbleiter-Wannen 43a, 44a und 45a je eine Schichtdicke c5, die alle vier annähernd gleich gross sind.

Die dritte Halbleiterzone 16 und der Anschlusskontakt 11c der Photodiode 1 besitzen je eine Schichtdicke d1, die Basiszone 18 und der Anschlusskontakt 12c des Vertikal-Bipolartransistors 4 je eine Schichtdicke d2, die Halbleiterzone 20a die Halbleiterzone 19c;19e und der Anschlusskontakt 13c des Lateral-Bipolartransistors 5 je eine Schichtdicke d3 sowie der Anschlusskontakt 36c des Widerstandes 6 eine Schichtdicke d4 (siehe Fig. 5) bzw. d5 (siehe Fig. 6), die alle fünf annähernd gleich gross sind.

Die Werte der Dotierung $N^+$ bzw. $P^+$ und der unterhalb der ersten Halbleiterzone 14 befindlichen aktiven Schichtdicke $W_1 = c1-b1$ der zweiten Halbleiterzone 15 der Photodiode 1 sowie die Werte der Dotierung P bzw. N und der unterhalb der Emitterzone 17 befindlichen aktiven Schichtdicke $W_2 = d2-c2$ der Basiszone 18 des Vertikal-Bipolartransistors 4 sind erfindungsgemäss so gewählt, dass die Ungleichheit

$$\int_{W_1} N^+ . dx \;>\; \int_{W_2} P . dx \qquad \text{bzw.} \qquad \int_{W_1} P^+ . dx \;>\; \int_{W_2} N . dx$$

erfüllt ist. Der Parameter x ist dabei eine senkrecht zur Oberfläche der integrierten Schaltung verlaufende Koordinate.

## Patentansprüche

1. Anordnung mit einer integrierten farbselektiven Photodiode (1) als Bauelement und einem der Photodiode (1) nachgeschalteten Verstärker (2), wobei die Photodiode (1) eine erste Halbleiterzone (14) eines ersten Leitfähigkeitstyps (P bzw. N) enthält, die an der Oberfläche einer zweiten Halbleiterzone (15) in der letzteren angeordnet ist, und wobei die zweite Halbleiterzone (15) von einem zweiten Leitfähigkeitstyp (N bzw. P) ist und ihrerseits an der Oberfläche einer dritten Halbleiterzone (16) in der letzteren angeordnet ist, welche vom ersten Leitfähigkeitstyp (P bzw. N) ist, dadurch gekennzeichnet, dass der Verstärker (2) mindestens einen Vertikal-Bipolartransistor (4) als Bauelement enthält, dass eine Epitaxieschicht (10) vom zweiten Leitfähigkeitstyp (N bzw. P) mittels Isolationsringe (11a;11b bzw. 12a;12b bzw. 13a;13b bzw. 36a;36b) in gegeneinander elektrisch isolierten Inseln aufgeteilt ist, in denen je ein Bauelement (1 bzw. 4 bzw. 5 bzw. 6) angeordnet ist, wobei die Inseln jeweils ein dem betreffenden Bauelement (1 bzw. 4 bzw. 5 bzw. 6) zugeordneter Teil der Epitaxieschicht (10) bilden, dass die dritte Halbleiterzone (16) der Photodiode (1) an der Oberfläche der Epitaxieschicht (10) in dem der Photodiode (1) zugeordneten Teil der Epitaxieschicht (10) angeordnet ist, dass eine Emitterzone (17) des Vertikal-Bipolartransistors (4) vom zweiten Leitfähigkeitstyp (N bzw. P) ist, eine ähnliche Dotierung und Schichtdicke (c2) besitzt wie die zweite Halbleiterzone (15) der Photodiode (1) und an der Oberfläche einer Basiszone (18) des Vertikal-Bipolartransistors (4) in der Basiszone (18) angeordnet ist, dass die Basiszone (18) des Vertikal-Bipolartransistors (4) vom ersten Leitfähigkeitstyp (P bzw. N) ist, eine ähnliche Dotierung und Schichtdicke (d2) besitzt wie die dritte Halbleiterzone (16) der Photodiode (1) und an der Oberfläche der Epitaxieschicht (10) in dem dem Vertikal-Bipolartransistor (4) zugeordneten Teil der Epitaxieschicht (10) angeordnet ist, der eine Kollektorzone des Vertikal-Bipolartransistors (4) bildet, und dass die Werte einer Dotierung $N^+$ beziehungsweise $P^+$ und einer unterhalb der ersten Halbleiterzone (14) befindlichen aktiven Schichtdicke $W_1$ (d. h. c1-b1) der zweiten Halbleiterzone (15) der Photodiode (1) sowie die Werte einer Dotierung P beziehungsweise N und einer unterhalb der Emitterzone (17) befindlichen aktiven Schichtdicke $W_2$ (d. h. d2-c2) der Basiszone (18) des Vertikal-Bipolartransistors (4) so gewählt sind, dass die Ungleichheit

$$\int\limits_{W_1} N^+.dx \;>\; \int\limits_{W_2} P.dx \Big) \text{beziehungsweise} \int\limits_{W_1} P^+.dx \;>\; \int\limits_{W_2} N.dx$$

erfüllt ist, wobei x eine senkrecht zur Oberfläche der integrierten Schaltung verlaufende Koordinate ist.

2. Anordnung nach Anspruch 1, dadurch gekennzeichnet, dass der Verstärker (2) mindestens einen Lateral-Bipolartransistor (5) als Bauelement enthält, dass eine zentrale Emitterzone (20a;20b) und eine Kollektorzone (19a;19b) des Lateral-Bipolartransistors (5) vom ersten Leitfähigkeitstyp (P bzw. N) sind, eine ähnliche Dotierung und Schichtdicke (d3) besitzen wie die dritte Halbleiterzone (16) der Photodiode (1) und an der Oberfläche der Epitaxieschicht (10) in einem dem Lateral-Bipolartransistor (5) zugeordneten Teil der Epitaxieschicht (10) angeordnet sind, der eine Basiszone des Lateral-Bipolartransistors (5) bildet, und dass die Kollektorzone (19a;19b) so angeordnet ist, dass sie die zentrale Emitterzone (20a;20b), getrennt durch Halbleitermaterial der Epitaxieschicht (10), seitlich umgibt.

3. Anordnung nach Anspruch 1 oder 2, dadurch gekennzeichnet, dass mindestens ein im Verstärker (2) als Bauelement enthaltener integrierter Widerstand (6) eine Reihenschaltung mehrerer gleichgepolter P/N-Dioden (43, 44, 45) aufweist.

4. Anordnung nach Anspruch 3, dadurch gekennzeichnet, dass eine Halbleiter-Wanne (36c) des ersten Leitfähigkeitstyps (P bzw. N) an der Oberfläche der Epitaxieschicht (10) in dem dem integrierten Widerstand (6) zugeordneten Teil der Epitaxieschicht (10) angeordnet ist und eine ähnliche Dotierung sowie Schichtdicke (d5) besitzt wie die dritte Halbleiterzone (16) der Photodiode (1), dass an der Oberfläche der Halbleiter-Wanne (36c) in der letzteren soviele voneinander getrennte und gegeneinander elektrisch isolierte kleinere Halbleiter-Wannen (43a, 44a, 45a) des zweiten Leitfähigkeitstyps (N bzw. P) angeordnet sind, wie Anzahl P/N-Dioden (43, 44, 45) im integrierten Widerstand (6) enthalten sind, wobei die kleineren Halbleiter-Wannen (43a, 44a, 45a) jeweils eine ähnliche Dotierung und Schichtdicke (c5) wie die zweite Halbleiterzone (15) der Photodiode (1) besitzen, und dass in jeder kleineren Halbleiter-Wanne (43a, 44a, 45a) an der Oberfläche zwei Anschlusskontakte (43b, 43c bzw. 44b, 44c bzw. 45b, 45c) angeordnet sind, die sich beide mindestens teilweise überlappen und beide stark mit Fremdatomen dotiert sind, wobei jeweils ein erster der beiden Anschlusskontakte (43c, 44c, 45c) vom ersten Leitfähigkeitstyp (P bzw. N) und ein zweiter der beiden Anschlusskontakte (43b, 44b, 45b) vom zweiten Leitfähigkeitstyp (N bzw. P) ist.

5. Anordnung nach einem der Ansprüche 1 bis 4, dadurch gekennzeichnet, dass die Anordnung in einem Gehäuse aus durchsichtigem Kunststoff angeordnet ist.

## Claims

1. An arrangement with an integrated colour-selective photodiode (1) as a component and an amplifier (2) connected on the output side of the photodiode (1), wherein the photodiode (1) includes a first semiconductor zone (14) of a first conductivity type (P or N) which is arranged at the surface of a second semiconductor zone (15) in the latter and wherein the second semiconductor zone (15) is of a second conductivity type (N or P respectively) and in turn is arranged at the surface of a third semiconductor zone (16) in the latter, which is of the first conductivity type (P or N respectively), characterised in that the amplifier (2) includes at least one vertical bipolar transistor (4) as a component, that an epitaxial layer (10) of the second conductivity type (N or P respectively) is divided by means of insulating rings (11a; 11b or 12a; 12b or 13a; 13b or 36a; 36b) into mutually electrically insulated islands in each of which is arranged a respective component (1 or 4 or 5 or 6), wherein the islands each form a part of the epitaxial layer (10), which is associated with the component (1 or 4 or 5 or 6) in question, that the third semiconductor zone (16) of the photodiode (1) is arranged at the surface of the epitaxial layer (10) in the part of the epitaxial layer (10) which is associated with the photodiode (1), that an emitter zone (17) of the vertical bipolar transistor (4) is of the second conductivity type (N or P respectively), has a similar doping and is of a similar layer thickness (c2) to the second semiconductor zone (15) of the photodiode (1) and is arranged at the surface of a base zone (18) of the vertical bipolar transistor (4) in the base zone (18), that the base zone

7

(18) of the vertical bipolar transistor (4) is of the first conductivity type (P or N respectively), has a similar doping and is of a similar layer thickness (d2) to the third semiconductor zone (16) of the photodiode (1) and is arranged at the surface of the epitaxial layer (10) in the part of the epitaxial layer (10) which is associated with the vertical bipolar transistor (4) and which forms a collector zone of the vertical bipolar transistor (4), and that the values of a doping $N^+$ and $P^+$ respectively and an active layer thickness $W_1$ (that is to say c1-b1), beneath the first semiconductor zone (14), in respect of the second semiconductor zone (15) of the photodiode (1) and the values of a doping P or N respectively and an active layer thickness $W_2$ (that is to say d2-c2), beneath the emitter zone (17), in respect of the base zone (18) of the vertical bipolar transistor (4) are so selected that the following respective inequalities are fulfilled:

$$\int_{W_1} N^+.dx \; > \; \int_{W_2} P.dx, \quad \text{and} \quad \int_{W_1} P^+.dx \; > \; \int_{W_2} N.dx$$

wherein x is a co-ordinate extending perpendicularly to the surface of the integrated circuit.

2. An arrangement according to claim 1 characterised in that the amplifier (2) includes at least one lateral bipolar transistor (5) as a component, that a central emitter zone (20a; 20b) and a collector zone (19a; 19b) of the lateral bipolar transistor (5) are of the first conductivity type (P and N respectively), have a similar doping and are of a similar layer thickness (d3) to the third semiconductor zone (16) of the photodiode (1) and are arranged at the surface of the epitaxial layer (10) in a part of the epitaxial layer (10) which is associated with the lateral bipolar transistor (5) and which forms a base zone of the lateral bipolar transistor (5), and that the collector zone (19a; 19b) is so arranged that it laterally surrounds the central emitter zone (20a; 20b), separated by semiconductor material of the epitaxial layer (10).

3. An arrangement according to claim 1 or claim 2 characterised in that at least one integrated resistor (6) which is included in the amplifier (2) as a component has a series circuit of a plurality of like-poled P/N-diodes (43, 44, 45).

4. An arrangement according to claim 3 characterised in that a semiconductor trough (36c) of the first conductivity type (P or N respectively) is arranged at the surface of the epitaxial layer (10) in the part of the epitaxial layer (10) which is associated with the integrated resistor (6), and has a similar doping and is of a similar layer thickness (d5) to the third semiconductor zone (16) of the photodiode (1), that arranged at the surface of the semiconductor trough (36c) in the latter are as many mutually separated and mutually electrically insulated smaller semiconductor troughs (43a, 44a, 45a) of the second conductivity type (N or P respectively), as the number of P/N-diodes (43, 44, 45) contained in the integrated resistor (6), wherein the smaller semiconductor troughs (43a, 44a, 45a) each have a similar doping and are of a similar layer thickness (c5) to the second semiconductor zone (15) of the photodiode (1), and that arranged in each smaller semiconductor trough (43a, 44a, 45a) at the surface are two connecting contacts (43b, 43c, and 44b, 44c, and 45b, 45c respectively) which both at least partially overlap each other and which are both heavily doped with impurity atoms, wherein a respective first one of the two connecting contacts (43c, 44c, 45c) is of the first conductivity type (P or N respectively) and a respective second one of the two connecting contacts (43b, 44b, 45b) is of the second conductivity type (N or P respectively).

5. An arrangement according to one of claims 1 to 4 characterised in that the arrangement is disposed in a housing of transparent plastics material.

## Revendications

1. Dispositif comportant une photodiode intégrée (1), sélective du point de vue des couleurs, en tant que composant et un amplificateur (2) branché en aval de la photodiode (1), et dans lequel la photodiode (1) contient une première zone semiconductrice (14) possédant un premier type de conductivité (P ou N) et qui est disposée au niveau de la surface d'une seconde zone semiconductrice (15) et dans cette dernière, et dans lequel la seconde zone semiconductrice (15) possède un second type de conductivité (N ou P) et est disposée pour sa part au niveau de la surface et dans une troisième zone semiconductrice (16), qui possède le premier type de conductivité (P ou N), caractérisé en ce que l'amplificateur (2) contient au moins un transistor bipolaire vertical (4) en tant que composant, qu'une couche épitaxiale (10) possédant le second type de conductivité (N ou P) est subdivisée, au moyen d'anneaux isolants (11a; 11b ou 12a; 12b ou 13a; 13b ou 36a; 36b) en des îlots électriquement isolés les uns des autres et dans lesquels est disposé respectivement un composant (1 ou 4 ou 5 ou 6), et dans lequel les îlots forment respectivement une partie de la couche épitaxiale (10), associée au composant considéré (1 ou 4 ou 5 ou 6), la troisième zone semiconductrice (16) de la photodiode (1) est disposée au niveau de la surface de la couche épitaxiale (10), dans la partie de cette couche épitaxiale (10) associée à la photodiode (1), une zone d'émetteur (17) du transistor bipolaire vertical (4) possède le second type de conductivité (N ou P) et un dopage et une épaisseur de couche (c2) qui sont semblables à ceux de la seconde zone semiconductrice (4) de la photodiode (1) et est disposée au niveau de la surface d'une zone de base (18) du transistor bipolaire vertical (4) et dans cette zone de base (18), la zone de base (18) du transistor bipolaire vertical (4) possède le premier type de conductivité (P ou N) et un dopage et une épaisseur de couche (c2) semblables à ceux de la troisième zone semiconductrice (16) de la photodiode (1) et disposée au niveau de la surface de la couche épitaxiale (10), dans la partie de la couche épitaxiale (10), qui est associée au transistor bipolaire vertical (4) et qui forme une zone de collecteur du transistor bipolaire vertical (4), et les valeurs d'un dopage $N^+$ ou $P^+$ et d'une épaisseur de couche active $W_1$ (c'est-à-dire c1-b1) située au-dessous de la première zone semiconductrice (14), de la seconde zone semiconductrice (15) de la photodiode (1) ainsi que les valeurs d'un dopage P ou N et d'une épaisseur de couche active $W_2$ (c'est-à-dire d2-c2), située au-dessous de la zone d'émetteur (17), de la zone de base (18) du transistor bipolaire vertical (4) sont choisies de telle sorte que l'inégalité

$$\int_{W_1} N^+.dx > \int_{W_2} P.dx, \quad ou \quad \int_{W_1} P^+.dx > \int_{W_2} N.dx$$

est satisfaite, x étant une coordonnée comptée perpendiculairement à la surface du circuit intégré.

2.  Dispositif selon la revendication 1, caractérisé en ce que l'amplificateur (2) contient au moins un transistor bipolaire latéral (5) en tant que composant, qu'une zone centrale d'émetteur (20a; 20b) et une zone de collecteur (19a; 19b) du transistor bipolaire latéral (5) possèdent le premier type de conductivité (P ou N) et un dopage et une épaisseur de couche (d3) semblables à ceux de la troisième zone semiconductrice (16) de la photodiode (1) et sont disposées au niveau de la surface de la couche épitaxiale (10) dans une partie de la couche épitaxiale (10), qui est associée au transistor bipolaire latéral (5) et qui forme une zone de base du transistor bipolaire latéral (5), et que la zone de collecteur (19a; 19b) est disposée de telle sorte qu'elle entoure latéralement la zone centrale d'émetteur (20a; 20b), en en étant séparée par le matériau semiconducteur de la couche épitaxiale (10).

3.  Dispositif selon la revendication 1 ou 2, caractérisé en ce qu'au moins une résistance intégrée (6), contenue en tant que composant dans l'amplificateur (2), possède un montage série formé de plusieurs diodes P/N de même polarité (43, 44, 45).

4.  Dispositif selon la revendication 3, caractérisé par le fait qu'une cuvette semiconductrice (36c) possédant le premier type de conductivité (P ou N) est disposée à la surface de la couche épitaxiale (10) dans la partie de cette couche épitaxiale (10) associée à la résistance intégrée (6) et possède un dopage ainsi qu'une épaisseur de couche (d5) semblables à ceux de la troisième zone semiconductrice (16) de la photodiode (1), qu'au niveau de la surface de la cuvette semiconductrice (36c) et à l'intérieur de cette dernière sont disposées autant de cuvettes semiconductrices plus petites (43a, 44a, 45a) séparées les unes des autres et isolées électriquement les unes par rapport aux autres et possédant le second type de conductivité (N ou P), qu'il y a de diodes P/N (43, 44, 45) dans la résistance intégrée (6), les cuvettes semiconductrices plus petites (43a, 44a, 45a) possédant respectivement un dopage et une épaisseur de couche (c5) semblables à ceux de la seconde zone semiconductrice (4) de la photodiode (1), et que dans chaque cuvette semiconductrice plus petite (43a, 44a, 45a) sont disposés, au niveau de la surface, deux contacts de raccordement (43b, 43c ou 44b, 44c ou 45b, 45c), qui se chevauchent au moins partiellement et sont dopés tous deux fortement avec des atomes étrangers, respectivement un premier des deux contacts de raccordement (43c, 44c, 45c) possédant le premier type de conductivité (P ou N) et l'un des deux contacts de raccordement (43b, 44b, 45b) possédant le second type de conductivité (N ou P).

9

5. Dispositif selon l'une des revendications 1 à 4, caractérisé par le fait que le dispositif est placé dans un boîtier réalisé en une matière plastique transparente.

**Fig. 1**

**Fig. 2**

**Fig. 3**

**Fig. 4**

Fig.5

Fig.6

Fig. 7

12